# EUROPEAN PATENT APPLICATION

(11) **EP 4 033 261 A1**
(43) Date of publication of application: **27.07.2022**
(21) Application number: 19945662.5
(22) Date of filing: 29.11.2019
(51) Int. Cl.: G01R 31/00

(54) **WIDEBAND MEASUREMENT DATA PROCESSING METHOD AND APPARATUS, ELECTRONIC DEVICE AND MEDIUM**

(30) Priority: 20.09.2019 CN 201910894030
(71) Applicant: China Electric Power Research Institute Company Limited, Beijing 100192 (CN); State Grid Corporation of China, Beijing 100031 (CN)
(72) Inventor: FAN, Chen, Beijing 100192 (CN); YAO, Jianguo, Beijing 100192 (CN); NI, Yimin, Beijing 100192 (CN); ZHANG, Haidong, Beijing 100192 (CN); ZHAO, Guoqing, Beijing 100192 (CN); SUN, Mingyang, Beijing 100192 (CN); YU, Fang, Beijing 100192 (CN); JIANG, Yulei, Beijing 100192 (CN)
(74) Representative: Meindl, Tassilo
(86) International application number: PCT/CN2019/121986
(87) International publication number: WO 2021/051656

(57) **Abstract**

Provided are a wideband measurement data processing method and apparatus, an electronic device and a medium. The method comprises: acquiring wideband measurement data of a substation; carrying out preprocessing analysis on the wideband measurement data to obtain a preprocessing analysis file; carrying out diagnosis analysis on the wideband measurement data, and obtaining a substation area analysis brief report in conjunction with the preprocessing analysis file; and transmitting the wideband measurement data, the preprocessing analysis file and the substation area analysis brief report to a master scheduling station, and receiving an operation control instruction of the master scheduling station, wherein the wideband measurement data comprises a wideband measurement value, a fault wave record file and alarm information, and the wideband measurement value comprises a fundamental wave measurement value, a harmonic measurement value and an inter-harmonic measurement value.

## Description

The present application claims priority to Chinese Patent Application No. 201910894030.4 filed with the China National Intellectual Property Administration (CNIPA) on Sep. 20, 2019, the disclosure of which is incorporated herein by reference in its entirety.

### TECHNICAL FIELD

The present invention relates to the field of power automation, for example, to a wide-frequency measurement data processing method, apparatus, an electronic device and a medium.

### BACKGROUND

With the large-scale exploration and utilization of renewable energy and the development of smart power grid, a large number of new power electronics equipment such as converters, inverters and unified power flow controller are introduced into the power grid. As a result, sub-synchronous oscillation and other disturbances occur frequently, and harmonic disturbances in the power grid tend to occur in a wide frequency domain. At present, the power grid has a weak capability in monitoring disturbance components of different frequencies. The measurement signals focused by all equipment such as a measurement and control apparatus, a phasor measurement unit (PMU), and a power quality monitoring apparatus included in a substation are signals based on a power frequency of 50Hz. The measurement and control device relates to measurement of voltage and current within the range of 13th harmonic, the phasor measurement unit relates to the phasor measurement of fundamental at the power frequency in the range of 45-55Hz, and the power quality monitoring apparatus is required to measure only voltage and current within the range of 19th harmonic at present, and may involve measurement of voltage and current within the range of 50th harmonic at most. However, as a large number of electric devices and electronic devices are used, the power grid signals become wide frequency signals based on the power frequency signal and containing a large number of inter-harmonics and high order harmonics. These non-power frequency inter-harmonic signals cause new types of sub/super-synchronous oscillations and even wide-frequency oscillations at higher frequencies, which adversely affects safe operation of the power grid.

In practical projects, modified PMUs can be used to monitor sub/super-synchronous oscillations. However, the amount of data of fundamental, inter-harmonic and high order harmonic increases with the large-scale application of power electronic devices. The current PMU transmission protocol cannot meet the transmission requirements of wide-frequency measurement data. Moreover, the Wide Area Measurement System(WAMS) only receives the fundamental phasor data based on the PMUs, the transmission of wide-frequency measurement data to dispatching center would increase the amount of work for data storage and analysis of dispatching center, consuming a large amount of human resources to monitor and analyze the wide-frequency measurement data and cause a waste of storage resources of the dispatching center for storing a large amount of wide-frequency measurement data, and affect the efficiency in monitoring operation of the dispatching center.

### SUMMARY

The present invention provides a wide-frequency measurement data processing method, which includes: acquiring wide-frequency measurement data of a substation; performing preprocessing analysis on the wide-frequency measurement data to obtain a preprocessing analysis file; performing diagnostic analysis on the wide-frequency measurement data, and obtaining a substation area analysis brief report in conjunction with the preprocessing analysis file; and transmitting the wide-frequency measurement data, the preprocessing analysis file, and the substation area analysis brief report to a dispatching center, and receiving operation control instructions from the dispatching center; where the wide-frequency measurement data includes a wide-frequency measurement value, a fault recording file, and alarm information, and the wide-frequency measurement value includes a fundamental measurement value, a harmonic measurement value, and an inter-harmonic measurement value.

The present invention further provides a wide-frequency measurement data processing apparatus, which includes: an acquisition module configured to acquire wide-frequency measurement data of a substation; an analyzing and processing module configured to perform preprocessing analysis on the wide-frequency measurement data to obtain a preprocessing analysis file, and perform diagnostic analysis on the wide-frequency measurement data, and obtain a substation area analysis brief report in conjunction with the preprocessing analysis file; and an external exchange module configured to transmit the wide-frequency measurement data, the preprocessing analysis file, and the substation area analysis brief report to a dispatching center, and receive operation control instructions from the dispatching center; where the wide-frequency measurement data includes a wide-frequency measurement value, a fault recording file, and alarm information, and the wide-frequency measurement value includes a fundamental measurement value, a harmonic measurement value, and an inter-harmonic measurement value.

The present invention further provides an electronic device, which includes: at least one processor; and a memory configured to store at least one computer program, when the at least one computer program is executed by the at least one processor, the at least one processor implements the wide-frequency measurement data processing method as described above.

The present invention further provides a computer-readable storage medium, storing computer-executable instructions for performing the wide-frequency measurement data processing method as described above. In the present invention, by performing the preprocessing analysis and diagnosing analysis on the wide-frequency measurement data, the preprocessing analysis files and substation area analysis brief reports are obtained, which can effectively provide more explicit and targeted conclusions for the dispatching center, simplify the data transmitted to the dispatching center, reduce the amount of working for data storing and analyzing by the dispatching center, effectively improve the capability and level of power grid operation monitoring, and ensure the safety of power grid operation.

### BRIEF DESCRIPTION OF DRAWINGS

FIG. 1 shows a flowchart of a wide-frequency measurement data processing method according to the present invention;
FIG. 2 shows a flowchart of a specific processing method of wide-frequency measurement data according to an embodiment of the present invention;
FIG. 3 is a structural diagram of a wide-frequency measurement data processing apparatus according to an embodiment of the present invention;
FIGS. 4 is another structural diagram of a wide-frequency measurement data processing apparatus according to an embodiment of the present invention; and
FIG. 5 is a structural diagram of hardware of an electronic device according to an embodiment of the present invention.

### DETAILED DESCRIPTION

For a better understanding of the present invention, the contents of the present invention are described hereinafter in connection with drawings and embodiments of the specification.

### Embodiment 1

In the present invention, analysis is made for the issues encountered in the practical projects that wide-frequency measurement data cannot be transmitted in a large amount due to the restriction imposed by the transmission channel and that the dispatching center is required to simplify the transmission data, such that a solution is proposed from the point of view of the self-monitoring operation of the power grid, which avoids the real-time transmission of a large amount of wide-frequency measurement data. Since when the power grid is in normal operation, a large amount of wide-frequency measurement data not only occupies the communication bandwidth seriously but also has no help to the operation and maintenance of the dispatching center, a solution is proposed in which the wide-frequency measurement data are preprocessed and analyzed in substation, and only the diagnostic analysis results are sent to the dispatching center.

In the present invention, a method for storing and analyzing wide-frequency measurement data in the substation area is proposed and a corresponding device is developed on the basis of guaranteeing real-time acquisition and measurement of wide-frequency measurement data, by which, not only unified reception, storage, query and display of the wide-frequency measurement data of full substation can be implemented in the substation area, but also preprocessing analysis and in-depth diagnostic analysis on a large number of wide-frequency measurement data can be performed, and various kinds of substation area analysis brief reports with reference to wide-frequency measurement data can be provided, which can effectively provide more explicit and targeted conclusions for the dispatching center, further simplify the transmission of wide-frequency measurement data to the dispatching center, and reduce the amount of working for the data storage and analysis of the dispatching center, thereby effectively improving the capability and level of power grid operation monitoring, ensuring the operation safety of the power grid, and making the operation monitoring by the dispatching center more targeted.

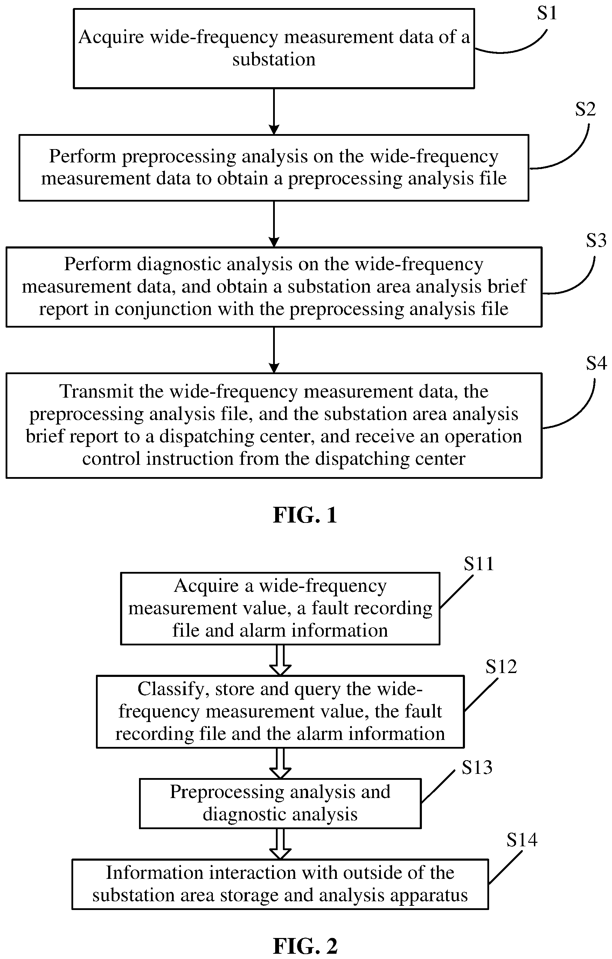

As shown in FIG. 1, the technical solution according to the present invention is a wide-frequency measurement data processing method, the method includes storing and analyzing wide-frequency measurement data.

The step S1 includes acquiring wide-frequency measurement data of a substation.

The step S2 includes performing preprocessing analysis on the wide-frequency measurement data to obtain a preprocessing analysis file.

The step S3 includes performing diagnostic analysis on the wide-frequency measurement data, and obtaining a substation area analysis brief report in conjunction with the preprocessing analysis file.

The step S4 includes transmitting the wide-frequency measurement data, the preprocessing analysis file, and the substation area analysis brief report to a dispatching center, and receiving operation control instructions from the dispatching center.

The wide-frequency measurement data includes a wide-frequency measurement value, a fault recording file, and alarm information, and the wide-frequency measurement value includes a fundamental measurement value, a harmonic measurement value, and an inter-harmonic measurement value.

The processing method shown in FIG. 1 is described with the processing method shown in FIG. 2 as follows.

In step S1, the acquiring wide-frequency measurement data of a substation includes: acquiring the wide-frequency measurement value and the alarm information in a data subscription manner; and acquiring the fault recording file by at least one of active uploading by an underlying apparatus, regular calling, and remote reading.

The fault recording file includes a configuration (CFG) file, a data (DATA) file, and a header (HDR) file, the HDR file includes an alarm information type, a start time of the fault recording and an end time of the fault recording, and configuration information of an apparatus, the fundamental measurement value includes a voltage fundamental measurement value and a current fundamental measurement value, the harmonic measurement value includes a voltage harmonic measurement value and a current harmonic measurement value, and the inter-harmonic measurement value includes a voltage inter-harmonic measurement value and a current inter-harmonic measurement value.

In step S11, acquisition of wide-frequency measurement values, a fault recording file and alarm information includes: one or more wide-frequency measurement apparatuses are provided in a bay level of the substation according to requirements for unified measurement of fundamentals, harmonics and inter-harmonics of the power grid, a substation area storage and analysis apparatus is installed in a substation control layer of the substation, and the substation area storage and analysis apparatus is connected to all the wide-frequency measurement apparatuses of the whole substation to obtain the wide-frequency measurement data, relevant files and alarm information of the whole substation.

The acquisition of wide-frequency measurement values, a fault recording file and alarm information includes the following steps: 1) apparatus connection; 2) data subscription; and 3) acquisition of a fault recording file.

In the step of 1) apparatus connection, the one or more wide-frequency measurement apparatuses are connected to the substation area storage and analysis apparatus in a direct connection manner or a separate networking manner. Generally, one wide-frequency measurement apparatus can be connected to one to four electrical bays. If a small number of wide-frequency measurement apparatuses are equipped in the substation, the wide-frequency measurement apparatuses can be connected to the substation area storage and analysis apparatus directly through a network. If more wide-frequency measurement apparatuses are equipped, with the number of which exceeds the number of ports accessible to the substation area storage and analysis apparatus, an independent wide-frequency measurement network is formed, and the substation area storage and analysis apparatus is directly connected to the network to access all the wide-frequency measurement apparatuses.

In the step of 2) data subscription, the wide-frequency measurement values and the alarm information required by the substation area storage and analysis apparatus are subscribed by remote configuration, and data subscription is implemented by configuring different objects. The wide-frequency measurement apparatus transmits fundamental, inter-harmonic and harmonic measurement values and each type of alarm information according to the subscribed objects, and the data is transmitted according to the International Electro technical Commission (IEC) 61850 standard.

In the step of 3) acquisition of a fault recording file, a fault recording file can be acquired by three manners, respectively, active uploading by an underlying apparatus, regular calling, and remote reading. In the active uploading mode, in a case where the substation area storage and analysis apparatus remotely sets the mode, once a fault recording file is generated, the wide-frequency measurement apparatus actively transmits the fault recording file to the substation area storage and analysis apparatus. In the regular calling mode, the substation area storage and analysis apparatus regularly calls the wide-frequency measurement apparatus for the fault recording file at a set time interval, and once a new recording file is generated, it is transmitted simultaneously, only the fault recording file generated latest is transmitted, and the fault recording file that has been transmitted is not transmitted again. In the remote reading manner, all the fault recording files are stored in the wide-frequency measurement apparatus. If the dispatching center needs to read a certain recording file, the fault recording file that needs to be read is targeted transmitted to the substation area storage and analysis apparatus at the time of reading. The fault recording file for wide-frequency measurement includes a CFG file, a DATA file, and an HDR file, specifically, the HDR file includes an alarm information type, a start time of the fault recording and an end time of the fault recording, and configuration information of an apparatus.

The method further includes classifying the wide-frequency measurement data, establishing association relationships between each type of data, and storing the wide-frequency measurement data. The establishing association relationships between each type of data and storing the wide-frequency measurement data includes: establishing association relationships between a same fault recording file triggered by different alarm information and corresponding wide-frequency measurement values, and establishing association relationships between different fault recording files triggered by a same alarm information and corresponding wide-frequency measurement values; storing the wide-frequency measurement values in a real-time database in dimensions of frequency, amplitude and time; storing the fault recording files in a file database in dimensions of a wide-frequency measurement apparatus, a bay, a start/end time; and storing the alarm information in an association database in an order of time of occurrence.

In step S12, the wide-frequency measurement value, the fault recording file and the alarm information are classified, stored and queried. After receiving the data from the wide-frequency measurement apparatuses of the whole substation, the substation area storage and analysis apparatus stores and associates the data, so as to facilitate the query and analysis in the future. The classifying and storing and querying the wide-frequency measurement value, the fault recording file and the alarm information includes the following procedures: 1) classifying and storing; and 2) querying wide-frequency measurement values; 3) querying a fault recording file; and 4) querying an alarm event.

In the procedure of 1) classifying and storing, the received wide-frequency measurement value, the fault recording file, and the alarm information are stored in categories, the fault recording file is stored in a file database, the wide-frequency measurement value is stored in a real-time database, and the alarm information is stored in the association database. At the same time, the fault recording files triggered by the same alarm will be associated automatically by the substation area storage and analysis apparatus to facilitate subsequent queries.

In the procedure of 2) querying wide-frequency measurement values, the wide-frequency measurement values have names of all the measurement values, that is, a voltage data or a current data, set by taking a range of frequency spectrum as a boundary, and precision of frequency resolution as a step, to form three queryable dimensions of frequency, amplitude, and time, specifically, the amplitude includes amplitudes of voltage and current. For example, if the range of the current stage wide-frequency measurement is 0-50 harmonics, i.e., 0-2500Hz, and the frequency resolution is 1Hz, then all the frequency bands are displayed as 0-2500Hz with the step of 1, and the voltage value and current value corresponding to each frequency band are displayed under the respective frequency band, and then the measurement values are stored according to time.

In the procedure of 3) querying a fault recording file, the fault recording file is stored and queried in three dimensions: a wide-frequency measurement apparatus, a bay, and a start/end time.

In the procedure of 4) querying an alarm event, the signals are stored in order of time of occurrence of the alarm events, and may be automatically associated with the fault recording file triggered by the alarm information. When an alarm event is queried, a corresponding recording file, if generated, is displayed together with the alarm event, and can be read directly.

After establishing association relationships between each type of data and storing the wide-frequency measurement data, the method further includes: querying the wide-frequency measurement value through the dimensions of frequency, amplitude, time; querying the fault recording file through the dimensions of the wide-frequency measurement apparatus, the bay, and the start/end time; and querying the alarm information through the occurrence time of the alarm and querying the fault recording file triggered by the alarm information and the wide-frequency measurement value corresponding to the alarm information.

The technical solution provided by the present invention can realize unified reception, storage and query of the wide-frequency measurement data of the whole substation, reduce the pressure in storage and analysis of the dispatching center, and improve the capability and level of the power grid operation monitoring.

In the step S2, the performing preprocessing analysis on the wide-frequency measurement data to obtain a preprocessing analysis file includes: performing statistics on a maximum value of harmonic amplitudes, a minimum value of the harmonic amplitudes and an average value of the harmonic amplitudes in a wide-frequency measurement range and a set time period in the wide-frequency measurement data to generate a harmonic preprocessing result; performing statistics on a maximum value of inter-harmonic amplitudes, a minimum value of the inter-harmonic amplitudes and an average value of the inter-harmonic amplitudes in a wide-frequency measurement range and the set time period in the wide-frequency measurement data to generate an inter-harmonic preprocessing result; analyzing, in the set time period of the wide-frequency measurement data, amplitudes corresponding to frequencies of dominant components of sub/super-synchronous oscillations and number of occurrences corresponding to the frequencies of the dominant components of the sub/super-synchronous oscillations at a same time, performing statistics on multiple dominant oscillation frequencies occurred according to both a dimension of frequency-amplitude and a dimension of frequency-number of occurrences, and sorting the multiple dominant oscillation frequencies respectively in order of amplitude and in order of the number of occurrences, and generating a preprocessing result of the sub/super-synchronous oscillation frequencies; and generating, at an interval being the set time period, the preprocessing analysis file by summarizing the harmonic preprocessing result, the inter-harmonic preprocessing result and the preprocessing result of the sub/super-synchronous oscillation frequencies, specifically, the preprocessing analysis file is generated in an extensible markup language, XML, format.

In step S13, preprocessing analysis and diagnostic analysis includes: for preprocessing analysis of wide-frequency measurement data, the substation area storage and analysis apparatus automatically performs preprocessing analysis after receiving all wide-frequency measurement data, performs filtering and statistics on each type of data, extracts characteristic result information, and then transmits it to the dispatching center, thereby simplifying information interaction and transmission with the dispatching center. The preprocessing analysis of the wide-frequency measurement data is performed by the following methods: 1) preprocessing of harmonics; 2) preprocessing of inter-harmonics; 3) preprocessing of frequencies in the sub/super-synchronous oscillation range; and 4) summarizing of preprocessing analysis results.

In the method of 1) preprocessing of harmonics, amplitudes of all harmonic voltages and harmonic currents within the wide-frequency measurement range are statistically summarized, and the maximum value of the amplitudes, minimum value of the amplitudes and average value of the amplitudes within the range of time T (e.g., 5 minutes) are obtained. If measurement range of the wide-frequency measurement apparatus at the current stage covers only the 50th harmonic, the maximum value, minimum value and average value of the harmonic voltages and harmonic currents within the range of 1-50th harmonics are monitored. The voltages and currents herein are three-phase voltages and three-phase currents, respectively.

In the method of 2) preprocessing of inter-harmonics, amplitudes of all inter-harmonic voltages and amplitudes of all inter-harmonic currents within the wide-frequency measurement range are statistically summarized, and the maximum value, minimum value and average value of the inter-harmonic voltages and inter-harmonic currents within the range of time T are obtained. The voltages and currents herein are three-phase voltages and three-phase currents, respectively.

In the method of 3) preprocessing of frequencies within the sub/super-synchronous oscillation range, the frequencies and amplitudes of N dominant oscillation components in the sub/super-synchronous oscillation range (e.g., the 2.5-100Hz range, specifically depends on the set range) in the range of time T are statistically analyzed, and N dominant oscillation frequency components are sorted out according to each of a dimension of frequency-amplitude and a dimension of frequency-number of occurrences. Maximum N frequencies are sorted out according to magnitude of amplitude in the dimension of frequency-amplitude, and maximum N frequencies are sorted out according to magnitude of the number of occurrences in the dimension of frequency-number of occurrences (N may be flexibly set, such as 10).

In the method of 4) summarizing of preprocessing analysis results, at an interval of time T, the preprocessing analysis results of the above-mentioned harmonic, inter-harmonic and sub/super-synchronous oscillation monitoring are formed into an independent preprocessing analysis file, and the preprocessing analysis file is in an XML format. The time T may be flexibly set according to requirements, for example, 5 minutes, 10 minutes, etc.

In an embodiment, the substation area analysis brief report includes an oscillation warning brief report, a sub/super-synchronous oscillation substation area analysis brief report, a sub-synchronous oscillation source locating brief report, and an inter-harmonic over-limit alarm substation area brief report.

In the step S3, the performing diagnostic analysis on the wide-frequency measurement data, and obtaining a substation area analysis brief report in conjunction with the preprocessing analysis file includes: performing statistical analysis on all bays of the substation based on data in the preprocessing analysis file, performing early warning in a case where a ratio of an inter-harmonic current to a set value is greater than a threshold value, and generating the oscillation warning brief report based on early warning information; based on data in the preprocessing analysis file, the fault recording file, and the alarm information, in a case where a sub/super-synchronous oscillation alarm occurs, continuously calculating dominant frequencies of an oscillation and oscillation amplitudes of the oscillation during a process of the oscillation until the oscillation disappears; at each dominant frequency, analyzing, a relationship between the oscillation amplitude and time, a relationship between an oscillation power and time, and a sub/super-synchronous oscillation damping ratio, and generating the sub/super-synchronous oscillation substation area analysis brief report; performing statistics on time slices of the sub/super-synchronous oscillation alarms based on the alarm information, and acquiring an order of time of occurrences of oscillation at all the bays, performing statistics on oscillation frequencies at all the bays based on magnitude of the oscillation amplitudes, sorting the oscillation bays in order of the magnitude of the oscillation amplitudes, and generating the sub-synchronous oscillation source locating brief report based on oscillation sources meeting an oscillation condition; analyzing by comparing an amplitude of each inter-harmonic and a total content of inter-harmonics within a range of wide-frequency signals in the preprocessing analysis file with set values, to obtain the frequencies of over-limit inter-harmonics, the amplitudes of the over-limit inter-harmonics and the total content of the over-limit inter-harmonics, and generating the inter-harmonic over-limit alarm substation area brief report. Specifically, the inter-harmonics include inter-harmonic voltages and inter-harmonic currents. For the diagnosis and analysis of the wide-frequency measurement data at the substation area level, the substation area storage and analysis apparatus performs the diagnosis and analysis on the basis of all the wide-frequency measurement values, the fault recording files, and the alarm information received and stored in addition to performing the preprocessing analysis, thereby simplifying the analysis working of the dispatching center, and providing the diagnosis and analysis result for the dispatching center. The diagnosis and analysis includes generating an oscillation warning brief report, a sub/super-synchronous oscillation substation area analysis brief report, a sub/super-synchronous oscillation source locating brief report, and an inter-harmonic over-limit alarm substation area brief report in a file manner, and store them as a brief report file in an XML format, specifically as follows.
(1) In generating the warning brief report, statistical analysis is performed on all bays of the substation on the basis of the preprocessing analysis results, and the bays where an oscillation or an over-limit alarm once occurred are focused. Once the ratio of the inter-harmonic current to a set value is greater than K (settable), an early warning is performed, and a warning brief report is generated.
(2) In generating the sub/super-synchronous oscillation substation area analysis brief report, on the basis of a preprocessing analysis result and since occurrence of a sub/super-synchronous oscillation alarm, dominant frequencies of an oscillation and amplitudes of the oscillation are continuously calculated during a process of the oscillation until the oscillation disappears. At each dominant frequency, a relationship between the oscillation amplitudes and time and a relationship between an oscillation power and time, and a sub/super-synchronous oscillation damping ratio are analyzed, thereby, the analysis brief report is generated.
(3) In generating the sub/super-synchronous oscillation source locating brief report, statistics and analysis on time slices of the sub/super-synchronous oscillation alarms are firstly performed from the total substation level on the basis of the preprocessing analysis result, and an order of time of occurrences of oscillations at all the bays is determined, then, statistics is performed on oscillation frequencies at all the bays according to the magnitude of the oscillation amplitudes, the oscillation bays are sorted in order of magnitude of the oscillation amplitudes, thereby, the determination and analysis brief report on suspicious oscillation sources is given.
(4) In generating the inter-harmonic over-limit alarm substation area brief report, the amplitudes of each inter-hormonic voltage and inter-hormonic current and total content of inter-harmonic voltages measured within the range of wide-frequency signals are compared with set values, on the basis of the preprocessing analysis results, to form an inter-harmonic voltage over-limit alarm brief report and an inter-harmonic current over-limit alarm brief report in which the frequencies of the over-limit inter-harmonic voltages and over-limit inter-harmonic currents and magnitudes of the over-limit inter-harmonic voltages and over-limit inter-harmonic currents, the total content of the corresponding inter-harmonic voltages and the total content of the corresponding inter-harmonic currents are given and stored in the form of a brief report.

In the step S4, the transmitting the wide-frequency measurement data, the preprocessing analysis file, and the substation area analysis brief report to a dispatching center, and receiving operation control instructions from the dispatching center includes: transmitting the fundamental measurement value and the alarm information of the wide-frequency measurement data to the dispatching center in real time; and transmitting the fault recording file, the preprocessing analysis file, the substation area analysis brief report, and a history data file to the dispatching center based on a requirement from the dispatching center.

The history data file is a file in a comma-separated value (CSV) format, and the history data file is generated according to data of frequency-amplitude-time acquired in a real-time database, a file database, and an association database and based on a dispatching center-specified substation, wide-frequency measurement apparatus, and a set bay.

According to yet another embodiment of the present invention, the transmitting the wide-frequency measurement data, the preprocessing analysis file and the substation area analysis brief report to a dispatching center, and receiving operation control instructions from the dispatching center, may include: transmitting the fundamental measurement values in the wide-frequency measurement data and the alarm information of the wide-frequency measurement data to the dispatching center in real time by using an extended recommended national standard GB/T26865.2 protocol, and transmitting the fault recording file, the preprocessing analysis file, the substation area analysis brief report, and the history data file to the dispatching center based on a requirement from the dispatching center.

The extended GB/T26865.2 protocol includes transmitting the fundamental measurement value, the harmonic measurement value, and the inter-harmonic measurement value by configuring original message data and by using an inter-frame gap between frames during message transmission, and transmitting the inter-harmonic measurement value and a high order harmonic measurement value by extending a message frame type.

According to the technical solution provided by the present invention, a large number of wide-frequency measurement data can be preprocessed and analyzed in depth, and each type of substation area analysis brief report can be given, which provides a more explicit and specific analysis result for the dispatching center, further simplifies the transmission of wide-frequency measurement data to the dispatching center, and ensures the operation safety of the power grid.

In step S14, external information interaction of the substation area storage and analysis apparatus includes: the substation area storage and analysis apparatus transmit the preprocessing analysis file, the substation area analysis brief report, the fault recording file, and the data information to the dispatching center according to a requirement from the dispatching center. The content of the transmission can be subscribed. Specifically, the following methods are used: (1) file transmission; (2) alarm information transmission; (3) real time-transmission of measurement value; and (4) transmission of files, alarm information and real time measurement data by using the extended GB/T26865.2 protocol.

In the method of (1) file transmission, the files to be transmitted to the dispatching center include a fault recording file, a preprocessing analysis file, a substation area analysis brief report, and a history data file. Specifically, In transmission of the history data file, a substation, a wide-frequency measurement apparatus and a bay can be specified, an interval being a set time period can be chosen, and three-dimensional data of frequency-amplitude-time can be acquired from the substation area storage apparatus, and transmitted in a CSV file format. The substation area analysis brief report includes each type of warning brief report, a sub/super-synchronous oscillation substation area analysis brief report, a sub/super-synchronous oscillation source locating brief report, and an inter-harmonic over-limit alarm substation area brief report.

In the method of (2) alarm information transmission, alarm information is transmitted to the dispatching center in real time when sub/super-synchronous oscillation and inter-harmonic over-limit alarm occur.

In the method of (3) real time-transmission of measurement value, the measurement value includes three-phase fundamental voltages, currents and frequencies of dynamic fundamental phasors. Numerical values of dominant oscillation frequencies and amplitudes during oscillation, and measurement data measured while no oscillation occurs are transmitted in a manner of statistical analysis file.

In the method of (4) transmission of files, alarm information and real-time measurement data by using the extended GB/T26865.2 protocol, the extended protocol has two extension manners, one is to transmit a fundamental, harmonic and inter-harmonic by configuring original message data and using an inter-frame gap between frames during message transmission, and the other is to transmit an inter-harmonic and a high order harmonic by extending a message frame type.

Apparently, the substation area storage and analysis apparatus mainly transmits the wide-frequency measurement data to the dispatching center, but it also retains interfaces for interacting with the substation equipment and the system to facilitate the transmission of alarm information and the like therebetween. The substation area storage and analysis apparatus transmits the data to other equipment and the monitoring system in the substation still by the IEC 61850 standard.

A wide-frequency measurement data processing apparatus is further provided according to the present invention, which is configured to receive, analyze and store wide-frequency measurement data, and may also be referred to as a substation area storage and analysis apparatus. At least one wide-frequency measurement apparatus and at least one substation area storage and analysis apparatus are included in a substation. The at least one wide-frequency measurement apparatus is connected to the substation area storage and analysis apparatus in a network direct connection manner or a separate networking manner. The wide-frequency measurement apparatus is arranged at a bay level of a substation to measure wide-frequency measurement data in the substation, and transmits the measured data to the substation area storage and analysis apparatus. The substation area storage and analysis apparatus is provided at a station-levelof a substation, is configured to store and analyze received wide-frequency measurement data, and generate a brief report file, and transmit the brief report file to a dispatching center based on an instruction. Specifically, the wide-frequency measurement data includes power grid fundamental data, harmonic data, and inter-harmonic data.

The substation area storage and analysis apparatus may be embodied as a conventional embedded device. Since the real-time requirements imposed on the apparatus are not high, the conventional Linux systems can meet the requirements. The apparatus is required to be configured with an IRIG-B-type timing function for its port, and the substation area storage and analysis apparatus is required to be configured with at least four 100 megabit communication network ports.

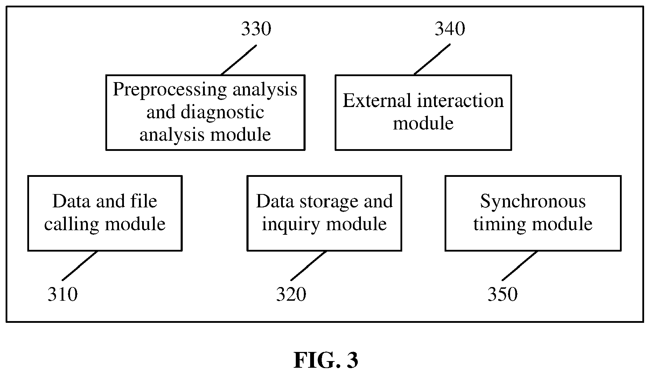

As shown in FIG. 3, a wide-frequency measurement data processing apparatus according to the present invention includes a data and file calling module 310, a data storage and inquiry module 320, a preprocessing analysis and diagnostic analysis module 330, and an external exchange module 340, these correspond to main functions in the method they implement, and a synchronization timing module 350 is additionally provided to receive timing signals in the format of inter-range instrumentation group-B (IRIG-B) provided by other external devices.

The function of the processing apparatus in this embodiment is as follows.
1) The data and file calling module 310 is configured to acquire wide-frequency measurement data, a fault recording file, and alarm information of a substation.
2) The data storage and inquiry module 320 is configured to classify and store real-time wide-frequency measurement data, alarm information, and fault recording files, and provide services of automatic association and query of wide-frequency measurement data, alarm information, and recording files.
3) The preprocessing analysis and diagnostic analysis module 330 is configured to perform preprocessing statistical analysis on the wide-frequency measurement data, to form the statistical analysis result into a preprocessing statistical analysis file, and perform diagnostic analysis on the wide-frequency measurement data, the alarm information and the fault recording file of the whole substation, to form substation area diagnostic analysis results, and form each type of substation area diagnostic analysis result into a substation area analysis brief report.
4) The external exchange module 340 is configured to transmit the wide-frequency measurement data, the preprocessing statistical analysis file, each type of substation area analysis brief report, and the fault recording file to the dispatching center, and receive operation control instructions from the dispatching center.
5) A synchronous timing module 350 is configured to receive an IRIG-B-formatted timing signal from external.

### Embodiment 2

A method for processing wide-frequency measurement data according to the present invention, includes the following steps: 1) acquiring wide-frequency measurement data of a whole substation; 2) classifying and storing the wide-frequency measurement data, and establishing associated connections to facilitate query; 3) performing preprocessing analysis and diagnostic analysis on the wide-frequency measurement data in sequence; 4) transmitting the wide-frequency measurement raw data, the preprocessing analysis data and the diagnostic analysis result data to external while receiving operation control instructions from external.

### 1) The wide-frequency measurement data of the whole substation is acquired in the following manner.

(1) The data subscription manner may be implemented by remote configuration, and data acquisition may be implemented by configuring different data objects.
(2) The acquired wide-frequency measurement data contains real-time measured power frequency signal measurement values, inter-harmonic measurement values, harmonic measurement values, and each type of alarm information.
(3) The acquired fault recording file includes a CFG file, a DATA file, and an HDR file, specifically, the HDR file includes an alarm information type, a start time of the fault recording, an end time of the fault recording, and configuration information of an apparatus.
(4) The fault recording file can be acquired in three manners, namely, active uploading by an underlying apparatus, regular calling, and remote reading.

The wide-frequency measurement data in the present invention includes a wide-frequency measurement value, a fault recording file, and alarm information, specifically, the wide-frequency measurement value includes a fundamental measurement value, a harmonic measurement value, and an inter-harmonic measurement value.

### 2) The following method is used for storing the wide-frequency measurement data.

(1) The received wide-frequency measurement data are classified and stored, the fault recording file is stored in a file database, the wide-frequency measurement value is stored in a real-time database, and the alarm data is stored in an association database according to association relationships.
(2) The wide-frequency measurement values have names of all the measurement data set by taking a range of frequency spectrum as a boundary, and precision of frequency resolution as a step, to display current amplitudes corresponding to all the frequencies respectively, and the data is then stored according to time to form storage and query dimensions of frequency, amplitude, and time.
(3) The fault recording file is stored and queried in three dimensions: a wide-frequency measurement apparatus, a bay, and a start/end time of the fault recording.
(4) The alarm signals are stored in order of time of occurrences of all events, and may also be automatically associated with the fault recording file triggered by the alarm information to establish association relationships between the alarm information, the fault recording file and corresponding wide-frequency measurement values.

### 3-1) The following method is used for preprocessing the wide-frequency measurement data.

(1) Statistics on the maximum value, minimum value and average value of all harmonic amplitudes of the three-phase voltage within a wide-frequency measurement range within time T and the maximum value, minimum value and average value of all harmonic amplitudes of the three-phase current within the wide-frequency measurement range within time T is performed.
(2) Statistics on the maximum value, minimum value and average value of all inter-harmonic amplitudes of the three-phase voltage within the wide-frequency measurement range within time T and the maximum value, minimum value and average value of all inter-harmonic amplitudes of the three-phase current within the wide-frequency measurement range within time T is performed.
(3) Frequencies of dominant components of sub/super-synchronous oscillation and amplitudes corresponding to the frequencies of the dominant components of the sub/super-synchronous oscillation and number of occurrences corresponding to the frequencies of the dominant components of the sub/super-synchronous oscillation are statistically analyzed. Specifically, frequencies of multiple dominant oscillation components in the sub/super-synchronous oscillation range in the range of time T and amplitudes of the multiple dominant oscillation components in the sub/super-synchronous oscillation range in the range of time T are statistically analyzed, and N dominant oscillation frequency components are sorted out according to each of a dimension of frequency-amplitude and a dimension of frequency-number of occurrences. Maximum N frequencies are sorted out by sorting the frequencies in order of amplitude in the dimension of frequency-amplitude, and another group of maximum N frequencies are sorted out by sorting the frequencies in order of number of occurrences in the dimension of frequency-number of occurrences.
(4) The results generated from the above (1)-(3) statistics steps form a preprocessed statistical analysis file of the wide-frequency measurement data, and a file is generated every time period T, and the time period T can be flexibly set.

### 3-2) The following methods are used in the in-depth analysis of the wide-frequency measurement data.

(1) An oscillation warning brief report, a sub/super-synchronous oscillation substation area analysis brief report, a sub-synchronous oscillation source locating brief report, and an inter-harmonic over-limit alarm substation area brief report are generated in the form of files, and are stored as brief report files, all of the files are in XML format.
(2) Generating oscillation warning brief report is based on the preprocessing analysis results, statistical analysis is performed on all bays in the substation, and the bay where an oscillation or an over-limit alarm once occurred is focused. Once the ratio of the inter-harmonic current to a set value is greater than K, an early warning is performed, and a warning brief report is generated.
(3) Generating the sub/super-synchronous oscillation substation area analysis brief report starts with the occurrence of the sub/super-synchronous oscillation alarm, dominant frequencies and amplitudes of an oscillation are continuously calculated during a process of the oscillation until the oscillation disappears. At each dominant frequency, analysis is performed on a relationship between the oscillation amplitudes and time and a relationship between an oscillation power and time, and a sub/super-synchronous oscillation damping ratio, thereby, the sub/super-synchronous oscillation substation area analysis brief report is generated.
(4) In generating the sub/super-synchronous oscillation source locating brief report, first, time slices of the sub/super-synchronous oscillation alarms are analyzed from the whole substation level to determine an order of time of occurrences of oscillation at all the bays, then, statistics is performed on oscillation frequencies at all the bays according to the magnitude of the oscillation amplitudes, the oscillation bays are sorted in order of the oscillation amplitudes, and suspicious oscillation sources are determined to generate the sub/super-synchronous oscillation source locating brief report.
(5) In generating the inter-harmonic over-limit alarm substation area brief report, the amplitudes of each inter-harmonic voltage and each inter-harmonic current and total content of inter-harmonic voltages measured within the range of wide-frequency signals are compared with set values and analyzed, to form the inter-harmonic voltage over-limit alarm brief report and inter-harmonic current over-limit alarm brief report. Thereby, the frequencies and magnitudes of the over-limit inter-harmonic voltages and the frequencies and magnitudes of the over-limit inter-harmonic currents, corresponding total content of the inter-harmonic voltages and corresponding total content of the inter-harmonic currents are given to generate the inter-harmonic over-limit alarm substation area brief report.

### 4) The wide-frequency measurement raw measurement data, the preprocessing analysis data and the diagnostic analysis result data are transmitted to the outside using the following methods: (1) file transmission to the dispatching center; (2) alarm information transmission; (3) real-time transmission of wide-frequency measurement values; and (4) transmission standard.

(1) Files are transmitted to the dispatching center, the files include a fault recording file, a preprocessing analysis file, a substation area analysis brief report, and a history data file. specifically, for the history data file, a substation, a wide-frequency measurement apparatus and a bay can be specified, a set time period can be chosen, and three-dimensional data of frequency-amplitude-time can be acquired from the substation area storage apparatus, and transmitted in a CSV file format. The substation area analysis brief report includes each type of warning brief report, a sub/super-synchronous oscillation substation area analysis brief report, a sub/super-synchronous oscillation source locating brief report, and an inter-harmonic over-limit alarm substation area brief report.
(2) In the alarm information transmission, it is considered according to the present invention that in practical applications the dispatching center is mainly concerned with sub/super-synchronous oscillations and inter-harmonic over-limit alarms, therefore, when a sub/super-synchronous oscillation or an inter-harmonic over-limit alarm occurs, the alarm information is transmitted to the dispatching center in real time, such that the working of the dispatching center is simplified, and the amount of data to be transmitted to the dispatching center is reduced. In addition, the alarm content transmitted in real time may be set according to specific requirements.
(3) The transmission of the wide-frequency measurement values in real time includes transmission of three-phase fundamental voltages, three-phase fundamental currents and corresponding frequencies of dynamic fundamental phasors. Numerical values of dominant oscillation frequencies and numerical values of amplitudes during a process of oscillation, and measurement data generated while no oscillation occurs are transmitted in a manner of statistical analysis file.
(4) The documents, the alarm information and the wide-frequency measurement values involved in the above (1) to (3) are transmitted to the dispatching center in an extended GB/T26865.2 protocol manner, and are transmitted to other equipment and the monitoring system in the substation still by the IEC 61850 standard.

The extended GB/T26865.2 protocol in the present invention has the following two extension manners.
1) A fundamental, harmonic, and inter-harmonic are transmitted by configuring original message data and using an inter-frame gap between frames during message transmission.
2) An inter-harmonic and a high order harmonic are transmitted by extending a message frame type.

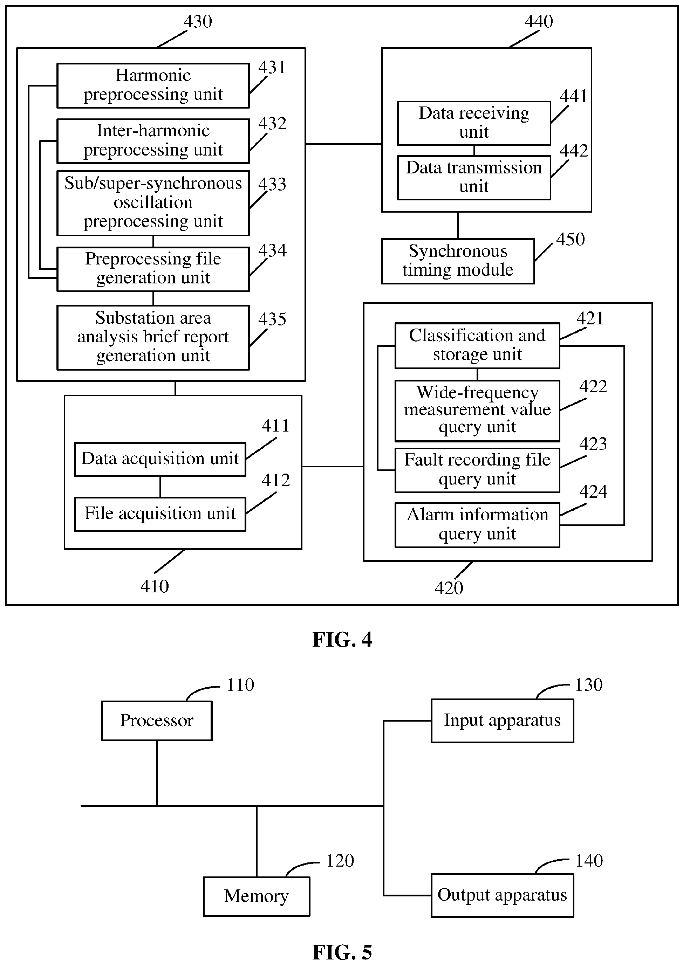

As shown in FIG. 4, the wide-frequency measurement data processing apparatus provided by the present invention mainly includes the following functional modules: 1) a wide-frequency measurement data and file calling module 410; 2) a wide-frequency measurement data storage and inquiry module 420; 3) a wide-frequency measurement data preprocessing analysis and diagnostic analysis module 430; 4) a wide-frequency measurement data external exchange module 440; and 5) a synchronous timing module 450.
1) The wide-frequency measurement data and file calling module 410 is configured to acquire wide-frequency measurement data of a substation.
2) The wide-frequency measurement data storage and inquiry module 420 is configured to classify and store wide-frequency measurement data, and provide services of automatic association and query of wide-frequency measurement values, alarm information, and fault recording files.
3) The wide-frequency measurement preprocessing analysis and diagnostic analysis module 430 is configured to perform preprocessing statistical analysis on the wide-frequency measurement data, to form the statistical analysis result into a preprocessing analysis file, and perform diagnostic analysis on the wide-frequency measurement values, the alarm information and the fault recording file of the whole substation, to form substation area diagnostic analysis results, and form each type of substation area diagnostic analysis result into a substation area analysis brief report.
4) The wide-frequency measurement data external exchange module 440 is configured to transmit the wide-frequency measurement data, the preprocessing statistical analysis file, each type of substation area analysis brief report, and the fault recording file to the dispatching center, and receive operation control instructions from the dispatching center.
5) The synchronous timing module 450 is configured to receive an IRIG-B-formatted timing signal from external.
1) The wide-frequency measurement data and file calling module 410 has the following features: (1) a data acquisition unit 411; and (2) a file acquisition unit 412.
(1) The data acquisition unit 411 is configured to acquire data by remotely configuring different data objects, the acquired data includes power frequency signal measurement values, inter-harmonic measurement values, harmonic measurement values, and each type of alarm information.
(2) The file acquisition unit 412 is configured to acquire a fault recording file including a CFG file, a DATA file, and an HDR file, specifically, the HDR file includes an alarm information type, a start time of the fault recording and an end time of the fault recording, and configuration information of an apparatus. The fault recording file can be acquired in three manners: respectively, active uploading by an underlying apparatus, regular calling, and remote reading.
2) The wide-frequency measurement data storage and inquiry module 420 includes the following features: a classification and storage unit 421; a wide-frequency measurement value query unit 422; a fault recording file query unit 423; and an alarm information query unit 424.
(1) The classification and storage unit 421 is configured to classify and store the received wide-frequency measurement data, store a fault recording file in a file database, store the wide-frequency measurement values in a real-time database, and store the alarm data in an association database according to association relationships.
(2) The wide-frequency measurement value query unit 422 is configured to set names of all the measurement data by taking a range of frequency spectrum as a boundary and precision of frequency resolution as a step, to display voltage amplitudes and current amplitudes corresponding to all the frequencies respectively, and then store the data according to time to form three queryable dimensions of frequency, amplitude and time.
(3) The fault recording file query unit 423 is configured to store and query fault recording files in three dimensions: a wide-frequency measurement apparatus, a bay, and a start/end time of the fault recording.
(4) The alarm information query unit 424 is configured to store the alarm information in order of time of occurrences of all the events, and to automatically associate a fault recording file triggered at a same time period.
3) The wide-frequency measurement data preprocessing analysis and diagnostic analysis module 430 includes the following features: a harmonic preprocessing unit 431; an inter-harmonic preprocessing unit 432; a sub/super-synchronous oscillation preprocessing unit 433; a preprocessing file generation unit 434; and a substation area analysis brief report generation unit 435.
(1) The harmonic preprocessing unit 431 is configured to perform statistics on a maximum value of harmonics, a minimum value of the harmonics, and an average value of the harmonics within a wide-frequency measurement range in a set time.
(2) The inter-harmonic preprocessing unit 432 is configured to perform statistics on a maximum value of amplitudes of the current inter-harmonics and voltage inter-harmonics, a minimum value of amplitudes of the current inter-harmonics and voltage inter-harmonics, and an average value of the amplitudes of the current inter-harmonics and voltage inter-harmonics within a set time.
(3) The sub/super-synchronous oscillation preprocessing unit 433 is configured to statistically analyze the frequencies and amplitudes of the N dominant oscillation components within the sub/super-synchronous oscillation range, and to statistically analyze the oscillation frequency with the maximum number of occurrences and the number of occurrences of this frequency within a set time.
(4) The preprocessing file generation unit 434 is configured to automatically form the statistical analysis results of the harmonic preprocessing unit, the inter-harmonic preprocessing unit, and the sub/super-synchronous oscillation preprocessing unit into a file, and output the preprocessing analysis file in the form of a file.
(5) The substation area analysis brief report generation unit 435 is configured to perform diagnostic analysis on the received wide-frequency measurement values, alarm information, and fault recording files, and generate each type of warning brief report, the sub/super-synchronous oscillation substation area analysis brief report, the sub/super-synchronous oscillation source locating brief report, and the inter-harmonic over-limit alarm substation area brief report, respectively, and the brief reports are outputted in the form of file.

The substation area analysis brief report generation unit 435 includes the following features.

Generating oscillation warning brief report is based on the preprocessing analysis results, statistical analysis is performed on all bays in the substation, and the bay where an oscillation or an over-limit alarm once occurred is focused. Once the ratio of the inter-harmonic current to a set value is greater than K, an early warning is performed, and a warning brief report is generated.

Generating the sub/super-synchronous oscillation substation area analysis brief report starts with the occurrence of the sub/super-synchronous oscillation alarm, dominant frequencies and amplitudes of an oscillation are continuously calculated during a process of the oscillation until the oscillation disappears. At each dominant frequency, analysis is performed on a relationship between the oscillation amplitudes and time and a relationship between an oscillation power and time, and a sub/super-synchronous oscillation damping ratio, thereby, the analysis brief report is generated.

In generating the sub/super-synchronous oscillation source locating brief report, first, time slices of the sub/super-synchronous oscillation alarms are analyzed from the whole substation level to determine an order of time of occurrences of oscillation at all the bays, then, statistics is performed on oscillation frequencies at all the bays according to the magnitude of the oscillation amplitudes, the oscillation bays are sorted in order of the oscillation amplitudes, and suspicious oscillation sources are determined to generate the sub/super-synchronous oscillation source locating brief report.

In generating the inter-harmonic over-limit alarm substation area brief report, the amplitudes of each inter-harmonic voltage and each inter-harmonic current and total content of inter-harmonic voltages measured within the range of wide-frequency signals are compared with set values and analyzed, to form the inter-harmonic over-limit alarm brief report. Thereby, the frequencies and magnitudes of the over-limit inter-harmonic voltages and the frequencies and magnitudes of the over-limit inter-harmonic currents, corresponding total content of the inter-harmonic voltages and corresponding total content of the inter-harmonic currents are given and stored in the form of brief report.
4) The wide-frequency measurement data external transmission module 440 includes the following features: a data receiving unit 441 and a data transmission unit 442.
(1) The data receiving unit 441 is configured to receive each type of wide-frequency measurement data, alarm information, a recording file and the like transmitted from external measurement apparatus, and receive external operation control instructions;
(2) The data transmission unit 442 is configured to transmit each type of file, alarm information, real-time measurement value, and the like to the outside, and supports transmission according to the IEC 61850 standard and extended GB/T26865.2 protocol.

There are two ways to extend the GB/T26865.2 protocol: One is to transmit a fundamental, harmonic, and inter-harmonic by configuring original message data and using an inter-frame gap between frames during message transmission; and the other is to transmit an inter-harmonic and a high order harmonic by extending a message frame type.

According to yet another embodiment of the present invention, a wide-frequency measurement data processing apparatus is provided, which includes an acquisition module; an analyzing and processing module; and an external exchange module

The acquisition module is configured to acquire wide-frequency measurement data of a substation.

The analyzing and processing module is configured to perform preprocessing analysis on the wide-frequency measurement data to obtain a preprocessing analysis file, and perform diagnostic analysis on the wide-frequency measurement data, and obtain a substation area analysis brief report in conjunction with the preprocessing analysis file.

Then external exchange module is configured to transmit the wide-frequency measurement data, the preprocessing analysis file, and the substation area analysis brief report to a dispatching center, and receive operation control instructions from the dispatching center.

Specifically, the wide-frequency measurement data includes a wide-frequency measurement value, a fault recording file, and alarm information, and the wide-frequency measurement value includes a fundamental measurement value, a harmonic measurement value, and an inter-harmonic measurement value.

The acquisition module includes: a data acquisition unit; and a file acquisition unit.

The data acquisition unit is configured to acquire the wide-frequency measurement value and the alarm information in a data subscription manner.

The file acquisition unit is configured to acquire the fault recording file by at least one of active uploading by an underlying apparatus, regular calling, and remote reading.

Specifically, the fault recording file includes a CFG file, a DATA file, and an HDR file, the HDR file includes an alarm information type, a start time of the fault recording and an end time of the fault recording, and configuration information of an apparatus, the fundamental measurement value includes a voltage fundamental measurement value and a current fundamental measurement value, the harmonic measurement value includes a voltage harmonic measurement value and a current harmonic measurement value, and the inter-harmonic measurement value includes a voltage inter-harmonic measurement value and a current inter-harmonic measurement value.

The apparatus further includes a storage module.

The storage module is configured to classify the wide-frequency measurement data, establish association relationships between each type of data, and store the wide-frequency measurement data.

The storage module includes: an association relationship establishing unit; a real-time database storage unit; a file database storage unit; and an association database storage unit.

The association relationship establishing unit is configured to establish association relationships between a same fault recording file triggered by different alarm information and corresponding wide-frequency measurement values, and establish association relationships between different fault recording files triggered by a same alarm information and corresponding wide-frequency measurement values.

The real-time database storage unit is configured to store the wide-frequency measurement values in a real-time database in dimensions of frequency, amplitude and time.

The file database storage unit is configured to store the fault recording files in a file database in dimensions of a wide-frequency measurement apparatus, a bay, a start/end time of fault recording.

The association database storage unit is configured to store the alarm information in an association database in an order of time of occurrence.

The apparatus further includes a query module, the query module includes: a data query unit; a fault recording file query unit; and an alarm information query unit.

The data query unit is configured to query the wide-frequency measurement values through the dimensions of frequency, amplitude, time.

The fault recording file query unit is configured to query the fault recording files through the wide-frequency measurement apparatus, the bay, and the start/end time.

The alarm information query unit is configured to query the alarm information through the time of occurrence the alarm and query the fault recording file triggered by the alarm information and the wide-frequency measurement value corresponding to the alarm information.

The analyzing and processing module includes: a harmonic preprocessing unit; an inter-harmonic preprocessing unit; a sub/super-synchronous oscillation preprocessing unit; and a preprocessing file generation unit.

The harmonic preprocessing unit is configured to perform statistics on a maximum value of harmonic amplitudes, a minimum value of the harmonic amplitudes, and an average value of the harmonic amplitudes in a wide-frequency measurement range and a set time period in the wide-frequency measurement data to generate a harmonic preprocessing result.

The inter-harmonic preprocessing unit is configured to perform statistics on a maximum value of inter-harmonic amplitudes, a minimum value of the of inter-harmonic amplitudes, and an average value of the inter-harmonic amplitudes in a wide-frequency measurement range and the set time period in the wide-frequency measurement data to generate an inter-harmonic preprocessing result.

The sub/super-synchronous oscillation preprocessing unit is configured to analyze, in the set time period of the wide-frequency measurement data, amplitudes corresponding to frequencies of dominant components of sub/super-synchronous oscillations and number of occurrences corresponding to the frequencies of the dominant components of the sub/super-synchronous oscillations at a same time, perform statistics on multiple dominant oscillation frequencies occurred according to each of a dimension of frequency-amplitude and a dimension of frequency-number of occurrences, and sort the multiple dominant oscillation frequencies respectively in order of amplitude and in order of number of occurrences, and generate a preprocessing result of the sub/super-synchronous oscillation frequencies.

The preprocessing file generation unit is configured to generate, at an interval being the set time period, the preprocessing analysis file by summarizing the harmonic preprocessing result, the inter-harmonic preprocessing result and the preprocessing result of the sub/super-synchronous oscillation frequencies, specifically, the preprocessing analysis file is generated in an XML format.

The substation area analysis brief report includes an oscillation warning brief report, a sub/super-synchronous oscillation substation area analysis brief report, a sub-synchronous oscillation source locating brief report, and an inter-harmonic over-limit alarm substation area brief report, and the analyzing and processing module further includes: an oscillation warning brief report generation unit; a sub/super-synchronous oscillation substation area analysis brief report generation unit; a sub-synchronous oscillation source locating brief report generation unit; and an inter-harmonic over-limit alarm substation area brief report generation unit.

The oscillation warning brief report generation unit is configured to perform statistical analysis on all bays of the substation based on data in the preprocessing analysis file, perform early warning in a case where a ratio of an inter-harmonic current to a set value is greater than a threshold value, and generate the oscillation warning brief report based on early warning information.

The sub/super-synchronous oscillation substation area analysis brief report generation unit is configured to, based on data in the preprocessing analysis file, the fault recording file, and the alarm information, in a case where a sub/super-synchronous oscillation alarm occurs, continuously calculate dominant frequencies of an oscillation and oscillation amplitudes of the oscillation during a process of the oscillation until the oscillation disappears; at each dominant frequency, analyze, a relationship between the oscillation amplitude and time, a relationship between an oscillation power and time and a sub/super-synchronous oscillation damping ratio; and generate the sub/super-synchronous oscillation substation area analysis brief report.

The sub-synchronous oscillation source locating brief report generation unit is configured to perform statistics on time slices of the sub/super-synchronous oscillation alarms based on the alarm information, and acquire an order of time of occurrences of oscillation at all the bays according to the time slices, perform statistics on oscillation frequencies at all the bays based on magnitude of the oscillation amplitudes, sort the oscillation bays in order of magnitude of the oscillation amplitudes, and generate the sub-synchronous oscillation source locating brief report based on oscillation sources meeting an oscillation condition.

The inter-harmonic over-limit alarm substation area brief report generation unit is configured to analyze by comparing an amplitude of each inter-harmonic and a total content of inter-harmonics within a range of wide-frequency signals in the preprocessing analysis file with set values, to obtain the frequencies of over-limit inter-harmonics, the amplitudes of the over-limit inter-harmonics and the total content of the over-limit inter-harmonics, and generate the inter-harmonic over-limit alarm substation area brief report. The inter-harmonics include inter-harmonic voltages and inter-harmonic currents.

The external exchange module includes: a data receiving unit; and a data transmission unit.

The data receiving unit is configured to receive each type of wide-frequency measurement values, alarm information, a fault recording file transmitted from external measurement apparatus, and receive external operation control instructions.

The data transmission unit is configured to transmit a fundamental measurement value in the wide-frequency measurement data and alarm information of the wide-frequency measurement data to the dispatching center in real time by using an extended GB/T26865.2 protocol, and transmit the fault recording file, the preprocessing analysis file, the substation area analysis brief report, and the history data file to the dispatching center based on a requirement from the dispatching center.

Specifically, the history data file is a file in a CSV format, and is generated according to data of frequency-amplitude-time acquired in a real-time database, a file database, and an association database and based on a dispatching center-specified substation, wide-frequency measurement apparatus, and a set bay.

The extension of the GB/T26865.2 protocol includes transmitting a fundamental, harmonic, and inter-harmonic by configuring original message data and using an inter-frame gap between frames during message transmission; and transmitting an inter-harmonic and a high order harmonic by extending a message frame type.

The device further includes a synchronous timing module.

The synchronous timing module is configured to receive the IRIG-B-formatted timing signal.

FIG. 5 is schematic view showing the structure of hardware of an electronic device according to an embodiment of the present invention. As shown in FIG. 5, the electronic device includes one or more processors 110 and a memory 120. A processor 110 is shown in FIG. 5 as an example.

The electronic device may further include an input device 130 and an output device 140.

The processor 110, the memory 120, the input device 130 and the output device 140 in the electronic device may be connected by a bus or other means. The connection by bus is shown in FIG. 4 as an example.

As a computer-readable storage medium, the memory 120 may be configured to store a software program, a computer-executable program, and a module. The processor 110 performs multiple functional applications and data processing by executing software programs, instructions, and modules stored in the memory 120 to implement any one of the methods of the embodiments described above.

The memory 120 may include a program storing area and a data storing area, specifically, the program storing area may store an operating system, an application program required by at least one function; and the data storing area may store data or the like created according to the use of the electronic device. In addition, the memory may include a volatile memory such as a random-access memory (RAM) and may also include a nonvolatile memory such as at least one dick memory, a flash memory, or other non-transient solid-state memories.

The memory 120 may be a non-transient computer storage medium or a transient computer storage medium. The non-transient computer storage medium includes, for example, at least one disk memory, a flash memory, or another nonvolatile solid-state memory. In some embodiments, the memory 120 may optionally include memory remotely disposed relative to the processor 110, which may be connected to the electronic device via a network. Examples of such a network may include the Internet, intranets, local area networks, mobile communication networks, and combinations thereof.

The input device 130 may be configured to receive input numeric or character information and to generate key signal inputs related to user settings and functional control of the electronic device. The output device 140 may include a display device such as a display screen.

It is further provided according to an embodiment of the present invention a computer-readable storage medium, which is configured to store computer-executable instructions for executing the method described above.

All or part of the procedures in the methods of the preceding embodiments may be implemented by related hardware executed by computer programs, these programs may be stored in a non-transient computer-readable storage medium, and during the execution of these programs, the procedures in the preceding method embodiments may be implemented. The non-transient computer-readable storage medium may be a magnetic disk, an optical disk, a read-only memory (ROM), or an RAM.

It is to be understood by those having ordinary skill in the art that embodiments of the present invention may be provided as methods, systems, or computer program products. Therefore, the present invention may take the form of completely hardware embodiments, completely software embodiments, or a combination of software and hardware embodiments. Further, the present invention may take the form of a computer program product implemented on one or more computer-usable storage media (including, but not limited to, magnetic disk storage, CD-ROM, optical storage, etc.) in which computer-usable program codes are contained.

The present invention is described with reference to flowcharts and/or block diagrams of methods, devices (systems), and computer program products according to embodiments of the present invention. It should be understood that computer program instructions may implement each flow and/or block in the flowcharts and/or block diagrams and a combination of flows and/or blocks in the flowcharts and/or block diagrams. These computer program instructions may be provided for a processor of a general-purpose computer, a special-purpose computer, an embedded processor, or another programmable data processing device to produce a machine so that instructions, which are executed via the processor of the computer or another programmable data processing device, create a means for implementing the functions specified in one or more flows in the flowcharts and/or in one or more blocks in the block diagrams.

These computer program instructions may also be stored in a computer-readable memory which is able to direct a computer or another programmable data processing device to operate in a particular manner so that the instructions stored in the computer-readable memory produce a manufactured article including instruction means which implement the functions specified in one or more flows in the flowcharts and/or in one or more blocks in the block diagrams.

These computer program instructions may also be loaded onto a computer or another programmable data processing device so that a series of operation steps are performed on the computer or another programmable device to produce processing implemented by a computer. Therefore, instructions executed on a computer or another programmable device provide steps for implementing the functions specified in one or more flows in the flowcharts and/or in one or more blocks in the block diagrams.

## Claims

1. A wide-frequency measurement data processing method, comprising:
acquiring wide-frequency measurement data of a substation;
performing preprocessing analysis on the wide-frequency measurement data to obtain a preprocessing analysis file;
performing diagnostic analysis on the wide-frequency measurement data, and obtaining a substation area analysis brief report in conjunction with the preprocessing analysis file;
transmitting the wide-frequency measurement data, the preprocessing analysis file, and the substation area analysis brief report to a dispatching center, and receiving operation control instructions from the dispatching center;
wherein the wide-frequency measurement data comprises a wide-frequency measurement value, a fault recording file, and alarm information, and the wide-frequency measurement value comprises a fundamental measurement value, a harmonic measurement value, and an inter-harmonic measurement value.

2. The method of claim 1, wherein the acquiring wide-frequency measurement data of a substation comprises:
acquiring the wide-frequency measurement value and the alarm information in a data subscription manner;
acquiring the fault recording file by at least one of active uploading by an underlying apparatus, regular calling and remote reading;
wherein the fault recording file comprises a configuration, CFG, file, a data file, and a header, HDR, file, the HDR file comprises an alarm information type, a start time of the fault recording and an end time of the fault recording, and configuration information of an apparatus, the fundamental measurement value comprises a voltage fundamental measurement value and a current fundamental measurement value, the harmonic measurement value comprises a voltage harmonic measurement value and a current harmonic measurement value, and the inter-harmonic measurement value comprises a voltage inter-harmonic measurement value and a current inter-harmonic measurement value.

3. The method of claim 1 or 2, after the acquiring wide-frequency measurement data of a substation, further comprising:
classifying the wide-frequency measurement data, establishing association relationships between each type of data and storing the wide-frequency measurement data.

4. The method of claim 3, wherein the establishing association relationships between each type of data and storing the wide-frequency measurement data comprises:
establishing association relationships between a same fault recording file triggered by different alarm information and corresponding wide-frequency measurement values, and establishing association relationships between different fault recording files triggered by a same alarm information and corresponding wide-frequency measurement values;
storing the wide-frequency measurement values in a real-time database in dimensions of frequency, amplitude and time;
storing the fault recording files in a file database in dimensions of a wide-frequency measurement apparatus, a bay, a start/end time; and
storing the alarm information in an association database in an order of time of occurrence.

5. The method of claim 4, after the establishing association relationships between each type of data and storing the wide-frequency measurement data, further comprising:
querying the wide-frequency measurement value through the dimensions of frequency, amplitude, time;
querying the fault recording files through the wide-frequency measurement apparatus, the bay, and the start/end time;
querying the alarm information through the occurrence time of the alarm and querying the fault recording file triggered by the alarm information and the wide-frequency measurement value corresponding to the alarm information.

6. The method of claim 1, wherein the performing preprocessing analysis on the wide-frequency measurement data to obtain a preprocessing analysis file comprises:
performing statistics on a maximum value of harmonic amplitudes, a minimum value of the harmonic amplitudes and an average value of the harmonic amplitudes in a wide-frequency measurement range and a set time period in the wide-frequency measurement data to generate a harmonic preprocessing result;
performing statistics on a maximum value of inter-harmonic amplitudes, a minimum value of the inter-harmonic amplitudes and an average value of the inter-harmonic amplitudes in a wide-frequency measurement range and the set time period in the wide-frequency measurement data to generate an inter-harmonic preprocessing result;
analyzing, in the set time period of the wide-frequency measurement data, amplitudes corresponding to frequencies of dominant components of sub/super-synchronous oscillation and number of occurrences corresponding to the frequencies of the dominant components of the sub/super-synchronous oscillation at a same time, performing statistics on a plurality of dominant oscillation frequencies occurred according to each of a dimension of frequency-amplitude and a dimension of frequency-number of occurrences, and sorting the plurality of dominant oscillation frequencies respectively in order of amplitude and in order of the number of occurrences, and generating a preprocessing result of the sub/super-synchronous oscillation frequencies; and
generating, at an interval being the set time period, the preprocessing analysis file by summarizing the harmonic preprocessing result, the inter-harmonic preprocessing result and the preprocessing result of the sub/super-synchronous oscillation frequencies, wherein the preprocessing analysis file is generated in an extensible markup language, XML, format.

7. The method of claim 6, wherein the substation area analysis brief report comprises an oscillation warning brief report, a sub/super-synchronous oscillation substation area analysis brief report, a sub-synchronous oscillation source locating brief report, and an inter-harmonic over-limit alarm substation area brief report;
the performing diagnostic analysis on the wide-frequency measurement data, and obtaining a substation area analysis brief report in conjunction with the preprocessing analysis file comprises:
performing statistical analysis on all bays of the substation based on data in the preprocessing analysis file, performing early warning in a case where a ratio of an inter-harmonic current to a set value is greater than a threshold value, and generating the oscillation warning brief report based on early warning information;
based on data in the preprocessing analysis file, the fault recording file, and the alarm information, in a case where a sub/super-synchronous oscillation alarm occurs, continuously calculating dominant frequencies of an oscillation and oscillation amplitudes of the oscillation during a process of the oscillation until the oscillation disappears; at each dominant frequency, analyzing, a relationship between the oscillation amplitude and time, a relationship between an oscillation power and time, and a sub/super-synchronous oscillation damping ratio; and generating the sub/super-synchronous oscillation substation area analysis brief report;
performing statistics on time slices of the sub/super-synchronous oscillation alarms based on the alarm information, and acquiring an order of time of occurrences of oscillations at all the bays, performing statistics on oscillation frequencies at all the bays based on magnitude of the oscillation amplitudes, sorting the oscillation bays in order of the magnitude of the oscillation amplitudes, and generating the sub-synchronous oscillation source locating brief report based on oscillation sources meeting an oscillation condition;
analyzing by comparing an amplitude of each inter-harmonic and a total content of inter-harmonics within a range of wide-frequency signals in the preprocessing analysis file with set values, to obtain the frequencies of over-limit inter-harmonics, the amplitudes of the over-limit inter-harmonics, and the total content of the over-limit inter-harmonics, and generating the inter-harmonic over-limit alarm substation area brief report, wherein the inter-harmonics comprise inter-harmonic voltages and inter-harmonic currents.

8. The method of claim 1 or claim 5, wherein the transmitting the wide-frequency measurement data, the preprocessing analysis file, and the substation area analysis brief report to a dispatching center comprises:
transmitting the fundamental measurement value and the alarm information of the wide-frequency measurement data to the dispatching center in real time;
transmitting the fault recording file, the preprocessing analysis file, the substation area analysis brief report, and a history data file to the dispatching center based on a need of the dispatching center;
wherein the history data file is a file in a comma-separated value CSV format, and the history data file is generated according to data of frequency-amplitude-time acquired in a real-time database, a file database, and an association database and based on a dispatching center-specified substation, wide-frequency measurement apparatus, and a set bay.

9. The method of claim 1 or 5, wherein the transmitting the wide-frequency measurement data, the preprocessing analysis file, and the substation area analysis brief report to a dispatching center comprises:
transmitting the fundamental measurement values and the alarm information of the wide-frequency measurement data to the dispatching center in real time by using an extended recommended national standard GB/T26865.2 protocol, and transmitting the fault recording file, the preprocessing analysis file, the substation area analysis brief report, and the history data file to the dispatching center based on a requirement from the dispatching center;
wherein the extended GB/T26865.2 protocol comprises transmitting the fundamental measurement value, the harmonic measurement value, and the inter-harmonic measurement value by configuring original message data and by using an inter-frame gap between frames during message transmission, and transmitting the inter-harmonic measurement value and a high order harmonic measurement value by extending a message frame type; and
wherein the history data file is a file in a comma-separated value format, and the history data file is generated according to data of frequency-amplitude-time acquired in a real-time database, a file database, and an association database and based on a dispatching center- specified substation, wide-frequency measurement apparatus, and a set bay.

10. A wide-frequency measurement data processing apparatus, comprising:
an acquisition module configured to acquire wide-frequency measurement data of a substation;
an analyzing and processing module configured to perform preprocessing analysis on the wide-frequency measurement data to obtain a preprocessing analysis file, and perform diagnostic analysis on the wide-frequency measurement data, and obtain a substation area analysis brief report in conjunction with the preprocessing analysis file;
an external exchange module configured to transmit the wide-frequency measurement data, the preprocessing analysis file, and the substation area analysis brief report to a dispatching center, and receive operation control instructions from the dispatching center;
wherein the wide-frequency measurement data comprises a wide-frequency measurement value, a fault recording file, and alarm information, and the wide-frequency measurement value comprises a fundamental measurement value, a harmonic measurement value, and an inter-harmonic measurement value.

11. The apparatus of claim 10, wherein the acquisition module comprises:
a data acquisition unit configured to acquire the wide-frequency measurement value and the alarm information in a data subscription manner;
a file acquisition unit configured to acquire the fault recording file by at least one of active uploading by an underlying apparatus, regular calling, and remote reading;
wherein the fault recording file comprises a configuration, CFG, file, a data file, and a header, HDR, file, the HDR file comprises an alarm information type, a start time of the fault recording and an end time of the fault recording, and configuration information of an apparatus, the fundamental measurement value comprises a voltage fundamental measurement value and a current fundamental measurement value, the harmonic measurement value comprises a voltage harmonic measurement value and a current harmonic measurement value, and the inter-harmonic measurement value comprises a voltage inter-harmonic measurement value and a current inter-harmonic measurement value.

12. The apparatus of claim 10 or 11, further comprising:
a storage module configured to classify the wide-frequency measurement data, establish an association relationship between each type of data, and store the wide-frequency measurement data.

13. The apparatus of claim 12, wherein the storage module comprises:
an association relationship establishing unit configured to establish association relationships between a same fault recording file triggered by different alarm information and corresponding wide-frequency measurement values, and establish association relationships between different fault recording files triggered by a same alarm information and corresponding wide-frequency measurement values;
a real-time database storage unit configured to store the wide-frequency measurement values in a real-time database in dimensions of frequency, amplitude and time;
a file database storage unit configured to store the fault recording files in a file database in dimensions of a wide-frequency measurement apparatus, a bay, a start/end time of fault recording;
an association database storage unit configured to store the alarm information in an association database in an order of time of occurrence.

14. The apparatus of claim 13, further comprising a query module, the query module comprising:
a data query unit configured to query the wide-frequency measurement values through the dimensions of frequency, amplitude, time;
a fault recording file query unit configured to query the fault recording files through the wide-frequency measurement apparatus, the bay, and the start/end time of fault recording;
an alarm information query unit configured to query the alarm information through the time of occurrence of the alarm and query the fault recording file triggered by the alarm information and the wide-frequency measurement value corresponding to the alarm information.

15. The apparatus of claim 10, wherein the analyzing and processing module comprises:
a harmonic preprocessing unit configured to perform statistics on a maximum value of harmonic amplitudes, a minimum value of the harmonic amplitudes, and an average value of the harmonic amplitudes within a wide-frequency measurement range and within a set time period in the wide-frequency measurement data to generate a harmonic preprocessing result;
an inter-harmonic preprocessing unit configured to perform statistics on a maximum value of inter-harmonic amplitudes, a minimum value of the inter-harmonic amplitudes, and an average value of the inter-harmonic amplitudes in a wide-frequency measurement range and the set time period in the wide-frequency measurement data to generate an inter-harmonic preprocessing result;
a sub/super-synchronous oscillation preprocessing unit configured to analyze, in the set time period of the wide-frequency measurement data, amplitudes corresponding to frequencies of dominant components of sub/super-synchronous oscillation and number of occurrences corresponding to the frequencies of the dominant components of the sub/super-synchronous oscillation at a same time, perform statistics on a plurality of dominant oscillation frequencies occurred according to each of a dimension of frequency-amplitude and a dimension of frequency-number of occurrences, and sort the plurality of dominant oscillation frequencies respectively in order of amplitude and in order of number of occurrences, and generate a preprocessing result of the sub/super-synchronous oscillation frequencies; and
a preprocessing file generation unit configured to generate, at a bay being the set time period, the preprocessing analysis file by summarizing the harmonic preprocessing result, the inter-harmonic preprocessing result and the preprocessing result of the sub/super-synchronous oscillation frequencies, wherein the preprocessing analysis file is generated in an extensible markup language XML format.

16. The apparatus of claim 15, wherein the substation area analysis brief report comprises an oscillation warning brief report; a sub/super-synchronous oscillation substation area analysis brief report; a sub-synchronous oscillation source locating brief report; and an inter-harmonic over-limit alarm substation area brief report;
the analyzing and processing module further comprises:
an oscillation warning brief report generation unit configured to perform statistical analysis on all bays of the substation based on data in the preprocessing analysis file, perform early warning in a case where a ratio of an inter-harmonic current to a set value is greater than a threshold value, and generate the oscillation warning brief report based on early warning information;
a sub/super-synchronous oscillation substation area analysis brief report generation unit configured to, based on data in the preprocessing analysis file, the fault recording file, and the alarm information, in a case where a sub/super-synchronous oscillation alarm occurs, continuously calculate dominant frequencies of an oscillation and oscillation amplitudes of the oscillation during a process of the oscillation until the oscillation disappears; at each dominant frequency, analyze, a relationship between the oscillation amplitude and time, a relationship between an oscillation power and time and a sub/super-synchronous oscillation damping ratio; and generate the sub/super-synchronous oscillation substation area analysis brief report;
a sub-synchronous oscillation source locating brief report generation unit configured to perform statistics on time slices of the sub/super-synchronous oscillation alarms based on the alarm information, and acquire an order of time of occurrences of oscillation at all the bays according to the time slices, perform statistics on oscillation frequencies at all the bays based on magnitude of the oscillation amplitudes, sort the oscillation bays in order of the oscillation amplitudes, and generate the sub-synchronous oscillation source locating brief report based on oscillation sources meeting an oscillation condition;
an inter-harmonic over-limit alarm substation area brief report generation unit configured to analyze by comparing an amplitude of each inter-harmonic and a total content of inter-harmonics within a range of wide-frequency signals in the preprocessing analysis file with set values, to obtain the frequencies of over-limit inter-harmonics, the amplitudes of the over-limit inter-harmonics and the total content of the over-limit inter-harmonics, and generate the inter-harmonic over-limit alarm substation area brief report, wherein the inter-harmonics comprise inter-harmonic voltages and inter-harmonic currents.

17. The apparatus of claim 10, wherein the external exchange module comprises:
a data receiving unit configured to receive each type of wide-frequency measurement values, alarm information, a fault recording file transmitted from external measurement apparatus, and receive external operation control instructions;
a data transmission unit configured to transmit the fundamental measurement values in the wide-frequency measurement data and the alarm information of the wide-frequency measurement data to the dispatching center in real time by using an extended GB/T26865.2 protocol, and transmit the fault recording file, the preprocessing analysis file, the substation area analysis brief report, and the history data file to the dispatching center based on a requirement from the dispatching center;
wherein the history data file is a file in a comma-separated value CSV format, and the history data file is generated according to data of frequency-amplitude-time acquired in a real-time database, a file database, and an association database and based on a dispatching center-specified substation, wide-frequency measurement apparatus, and a set bay;
the extension of the GB/T26865.2 protocol comprises transmitting the fundamental, harmonic, and inter-harmonic by configuring original message data and using an inter-frame gap between frames during message transmission; and transmitting the inter-harmonic and a higher-order harmonic by extending a message frame type.

18. The apparatus of claim 10, further comprising:
a synchronous timing module configured to receive an external inter-range instrumentation group IRIG-B-formatted timing signal.

19. An electronic device, comprising:
at least one processor; and
a memory configured to store at least one computer program,
when the at least one computer program is executed by the at least one processor, the at least one processor implements the wide-frequency measurement data processing method of any one of claims 1 to 9.

20. A computer-readable storage medium, storing computer-executable instructions for performing the wide-frequency measurement data processing method of any one of claim 1 to 9.
